# EUROPEAN PATENT APPLICATION

(11) **EP 2 058 864 A1**
(43) Date of publication of application: **13.05.2009**
(21) Application number: 07120094.3
(22) Date of filing: 06.11.2007
(51) Int. Cl.: H01L 31/032

(54) **Chalcogenide-based solar cell and method of manufacturing such a cell**

(71) Applicant: Advanced Surface Technology B.V., 8941 ZZ Leeuwarden (NL)
(72) Inventor: Nanu, Marian, 2652 BK Berkel en Rodenrijs (NL); Meester, Bernard, 2665 DR Bleiswijk (NL)
(74) Representative: Hatzmann, Martin

(57) **Abstract**

A thin-film solar cell comprising homojunctions between quaternary chalcogenide compounds is proposed. By using a chalcogenide layer of for example a Cu₂A_{X(d)}B_{Y(d)}Z₄ compound with amounts of A and B that vary with depth, d, in the chalcogenide layer, sufficient freedom is obtained to realize a transition from n-type to p-type conductivity in the chalcogenide layer without changing the lattice structure and with minimum change of lattice constant. This allows to obtain solar cells with good energy conversion efficiencies.

Two solar cell embodiments are described. In the first embodiment, a p-i-n configuration is realised by deposition of a layer of Cu₂A_{X(d)}B_{Y(d)}Z₄ quaternary chalcogenide in which relative amount of elements A and B varies with the depth so as to result in a change in conductivity from p-type to n-type, including a part of the layer with intrinsic conductivity. The n-type contact layer (NC), the photovoltaic layer (PV). and the p-type contact layer (PC) have respective crystal lattices that mutually are substantially coherent so as to form homojunctions. In the second embodiment a p-n configuration is realised by deposition of a layer of Cu₂A_{X(d)}B_{Y(d)}Z₄ quaternary chalcogenide in which relative amount of elements A and B varies with the depth so as to result in a change in conductivity from p-type to n-type. The p-type layer (PC) and the n-type layer (NC) have respective crystal lattices that mutually are substantially coherent so as to form substantially a p-n homojunction.

In another aspect, a method for manufacturing a solar cell as defined in claim 1-8 is provided. Advantageously, a single deposition process can be used to form the chalcogenide layer comprising parts with different types of conductivity. This allows an efficient manufacturing process in which the solar cell can be formed in a single deposition tool.

## Description

### Field

The present invention relates to a chalcogenide-based solar cell. Moreover the present invention relates to a method for manufacturing such a chalcogenide-based solar cell.

### Background

A photovoltaic cell provides conversion of solar visible radiation that impinges on the photovoltaic cell into electric energy. The use of solar cells to convert sunlight into electric energy may provide a sustainable source of energy. To this end, solar cells that have higher conversion efficiency and lower manufacturing costs are under investigation.

It is known to manufacture thin-film based solar cells using a chalcogenide material such as Copper Indium Sulphide (CIS) or Copper Indium Gallium Selenide (CIGS). These materials are intrinsic semiconductors and exhibit good light absorption characteristics. Therefore CIS or CIGS chalcogenides are used as photoactive materials (i.e., light absorbers) in thin-film solar cells. Typically, such a solar cell comprises p-n junctions between the photoactive material and a semiconductor of conductivity type opposite to that of the absorber. There are also cases when the intrinsic absorber material is confined between a first contact layer of p-type material and a second contact layer of n-type material (p-i-n configuration). The CIS-based or CIGS-based thin-film solar cells are known to have reasonable energy conversion efficiency. Due to the thin-film arrangement and the physical properties of the chosen materials the amount of materials in thin-film solar cell is strongly reduced.

Chalcogenide materials like Copper Indium Sulphide (CIS, CuInS₂) or Copper Indium Gallium Selenide (CIGS, Cu(In,Ga)S₂) possess a crystalline lattice structure known as chalcopyrite. The presence of defects in the lattice structure has detrimental effects on the energy conversion efficiency. The efficiencies of existing CIS-based thin-film solar cells are lower than the theoretical efficiencies because the structural defects act as recombination centres for the charges (electrons and holes). Typically since in solar cells based on the above mentioned chalcogenide materials the p-type semiconductor and the n-type semiconductor are different materials, the interfaces between the p-type and n-type semiconductors are incoherent (i.e. the lattice parameters of the respective layers do not match) giving rise to heterojunctions within the solar cell.

The presence of heterojunctions typically reduces the efficiency of the solar cell. This is due to charge recombination processes that may occur at the interface(s), as well as due to possible diffusion of chemical species at the interface(s), which can create undesired energy levels in the bandgap that will reduce the solar cell efficiency.

In addition, in heterojunction solar cells, buffer layers need to be added between the p-type layer and the n-type layer to allow formation/growth of each layer with the appropriate crystal lattice structure. The complexity of the manufacturing process increases due to the formation of such buffer layers and results in an increase of manufacturing costs.

Moreover, the interfaces between layers in heterojunction solar cells may not be well defined and suffer from composition gradients in one or more of the constituent chemical species, which can adversely affect the electronic function.

Moreover, it is desirable to develop alternative photovoltaic materials for solar cells because the reserves for Indium are expected to be only sufficient for at most a few decades (US Geological Survey, Mineral Commodity Summaries, January 2007).

European patent application No 534 459 describes problems due to heterojunctions. This publication starts from chalcopyrite structures like CuInSe2 and considers other materials obtained by substitution of combinations of other group I materials for Cu, combinations of other group III materials for In, and combinations of other group VI materials for Se. EP 534 459 describes that the problems due to heterojunctions can be avoided by means of doping with molecular beams to realize homojunctions. EP 534 459 also proposes to replace part of the Se (or other group VI elements) by group V, VII elements, such as N, P, As, Sb or Bi, F, Cl, Br and I.

### Summary

It is an object to provide a thin-film solar cell with a chalcogenide material that leads to good efficiency.

In one aspect, a solar cell as defined in claim 1 is provided.

By using a quarternary chalcogenide layer of for example a Cu₂Ax_{(d)}BY_{(d)}S₄ compound with amounts of A and B that vary with depth, d, in the chalcogenide layer, sufficient freedom is obtained to realize a transition from n-type to p-type conductivity in the chalcogenide layer without changing the lattice structure and with minimum change of lattice constant.

In another aspect, a method for manufacturing a solar cell as defined in claims 1-8 is provided. Advantageously, a single deposition process can be used to form the chalcogenide layer comprising parts with different types of conductivity. This allows an efficient manufacturing process in which the solar cell can be formed in a single deposition tool.

### Brief description of drawings

Below, the exemplary embodiments will be explained with reference to some drawings, which are intended for illustration purposes only and not as a limitation of the scope of protection as defined in the accompanying claims.

Figure 1 shows a cross-section of a first embodiment of solar cell.

Figure 2 shows a plot of X and Y values wherein material properties are indicated

Figure 3 shows a cross-section of a second embodiment of solar cell.

### Detailed description

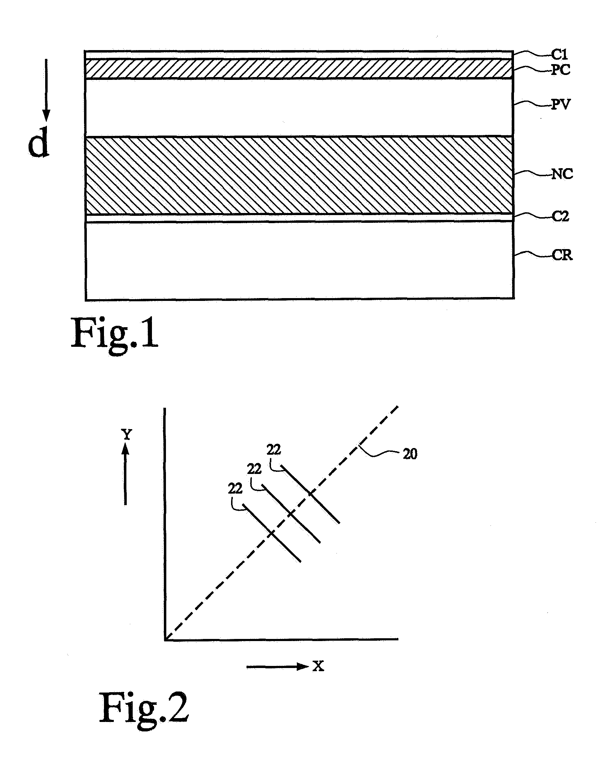

Figure 1 shows schematically a cross-section of a solar cell.

The solar cell 1 comprises a substrate SB on which a multilayer thin-film has been deposited. In this example, a n-type contact layer NC is applied on the surface of the substrate SB. Over the n-type contact layer NC a photovoltaic layer PV is deposited. A p-type contact layer PC is applied over the photovoltaic layer PV. In this embodiment a p-i-n junction is formed.

The n-type contact layer NC has a thickness dn. The photovoltaic layer PV has a thickness dv. The p-type contact layer PC has a thickness dp.

Optionally, a buffer layer (not shown) may be located between the photovoltaic layer PV and the n-type contact layer NC and/or between the photovoltaic layer PV and the p-type contact layer PC.

Contacts C1, C2 to the p-type contact layer PC and the n-type contact layer NC, respectively, are schematically indicated.

It is recognized that the photovoltaic layer PV consists of a quaternary chalcogenide compound Cu₂A_{X}B_{Y}S₄, in which element A is one from the group of elements Mg, Ca, Sr, Ba, Sc, Y, La, Eu, Gd, Er, Yb, Mn, Fe, Ag, Au, Zn, A1, Ga, Ge, Sn and Sb and element B is another one from the group of elements Sc, Y, La, Ce, Gd, Er, Yb, Fe, Al, Ga, Si, Ge , Sn, P, Sb, Ti, Zr, Hf, V, Nb, Ta, Mo, W and Re in which the element B is different from the element A. In the photovoltaic layer, the relative amounts X, Y respectively of elements A and B in combination are selected so as to obtain a photovoltaic material with a bandgap energy between about 1.2 eV and about 1.8 eV.

As example we can mention Cu₂Zn_{X}Sn_{Y}S₄ as preferred chalcogenide compound, i.e., A and B are Zn and Sn, respectively. When X=Y=1 a stoichiometric 2:1:1:4 compound (Cu₂ZnSnS₄), and therefore an intrinsic semiconductor, is formed. For small deviations from stoichiometry, i.e., 0.7<X<1.3 and 0.7<Y<1.3, such that X+Y=2, a change in conductivity is obtained. Due to the fact that Zn and Sn have comparable atomic radii the variation in lattice parameter upon changing the composition within the above-specified boundaries is below 10%. Compositions with X and Y outside this range result in the formation of other compounds that precipitate inside the chalcopyrite structure. Such precipitates can act as charge recombination sites, thereby reducing the energy conversion efficiency.

Figure 2 shows a plot of material properties for different combinations of X and Y values. A first line 20 indicates a borderline between combinations that result in p-type conductivity and n-type conductivity. First line 20 itself represents combinations that result in intrinsic conductivity type. The position of this line depends on the materials A and B and can easily be determined. Typically, it occurs for stoichiometric ratios of A and B. Compositions corresponding to points in the space above line 20 (X<Y) result in different type of conductivity than those corresponding to points in the space below line 20 (X>Y). Each of the second lines 22 show a collection of combinations of X and Y values that result in mutually matching lattices. As will be appreciated second lines 22 are shown by way of example only: any number of such lines may be drawn, each corresponding to a lattice with a different lattice constant and each second line may be extended further than the lines shown in the figures, to other X-Y combinations with the same lattice. Second lines 22 also depend on choice of A and B. When materials with equivalent effects on crystal properties are used, second lines 22 approximately satisfy relations X+Y=C, each for a different value of the constant C. As will be understood a layer that exhibits a transition from p-type to n-type without change in crystal structure can be realized by varying the combination of X and Y values with depth along any one of second lines 22, between points on either side of first line 20.

Advantageously, the combination of elements A and B in the photovoltaic material can replace the element Indium which is becoming scarce, while the quaternary compound has physical and electronic properties of a photovoltaic material, which are similar to those of Copper Indium Sulphide.

At the same time, the p-type contact layer PC consists also of a quaternary compound p-Cu₂A_{Xp}B_{Yp}S₄, in which the ratio of the relative amounts Xp, Yp of element A and element B, respectively, is selected in such a way that the compound p-Cu₂A_{Xp}B_{Yp}S₄ has electronic characteristics of a p-type semiconductor, while the crystalline structure of the compound p-Cu₂A_{Xp}B_{Yp}S₄ is substantially identical to the crystalline structure of the compound Cu₂A_{X}B_{Y}S₄ of the photovoltaic layer PV.

For the example of Cu₂ZnSnS₄ as PV compound, an excess of Zn will result in an increase in the concentration of holes, and therefore a higher mobility for this type of charges. Hence compounds such as Cu₂Zn_{Xp}Sn_{Yp}S₄ where 0.7<Xp<1.3, 0.7<Yp<1.3, Xp>Yp and Xp+Yp=2, have p-type conductivity. Due to the fact that Zn and Sn have comparable atomic radii the variation in lattice parameter upon changing the composition within the above-specified boundaries is below 10%. Compositions with Xp and Yp outside this range result in the formation of other compounds that precipitate inside the chalcopyrite structure. Such precipitates can act as charge recombination sites, thereby reducing the energy conversion efficiency.

Advantageously, the compound p-Cu₂A_{Xp}B_{Yp}S₄ of the p-type contact layer PC can be coherent with the compound Cu₂A_{X}B_{Y}S₄ of the photovoltaic layer PV. The coherency is schematically indicated by a dashed line between the layer PC and PV. The mismatch between the lattice of the PC layer and the lattice of the PV layer is reduced. As a result the recombination effects at the interface between the PC layer and the PV layer is reduced and the efficiency of the solar cell is increased.

Similarly, the n-type contact layer NC consists of a quaternary compound n-Cu₂A_{Xn}B_{Yn}S₄, in which the ratio of the relative amounts Xn, Yn of element A and element B, respectively, is selected in such a way that the compound n-Cu₂A_{Xn}B_{Yn}S₄ has electronic characteristics of an n-type semiconductor, while the crystalline structure of the compound n-Cu₂A_{Xn}B_{Yn}S₄ is substantially identical to the crystalline structure of the compound Cu₂A_{X}B_{Y}S₄ of the photovoltaic layer PV.

For the example of Cu₂ZnSnS₄ as PV compound, an excess of Sn will result in an increase in the concentration of electrons, and therefore a higher mobility for this type of charges. Hence compounds such as Cu₂Zn_{Xn}Sn_{Yn}S₄ where 0.7<Xn<1.3, 0.7<Yn<1.3, Xn<Yn and Xn+Yn=2, have n-type conductivity. Due to the fact that Zn and Sn have comparable atomic radii the variation in lattice parameter upon changing the composition within the above-specified boundaries is below 10%. Compositions with Xn and Yn outside this range result in the formation of other compounds that precipitate inside the chalcopyrite structure. Such precipitates can act as charge recombination sites, thereby reducing the energy conversion efficiency.

Advantageously, the compound n-Cu₂A_{Xn}B_{Yn}S₄ of the n-type contact layer NC can be coherent with the compound Cu₂A_{X}B_{Y}S₄ of the photovoltaic layer PV, which reduces the mismatch between the lattice of the NC layer and the lattice of the PV layer. The coherency is schematically indicated by a dashed line between the layer NC and PV. As a result the recombination effects at the interface between the NC layer and the PV layer is reduced and the efficiency of the solar cell is increased.

Additionally, the use of n-Cu₂A_{Xn}B_{Yn}S₄ and p-Cu₂A_{Xp}B_{Yp}S₄ contact layers has the advantage that in particular the copper and sulphur concentration in the contact layers PC, NC and in the photovoltaic layer PV is substantially the same. This reduces the risk of diffusion of elements from one layer to another one of the layers, which in heterojunction systems would adversely affect the composition of each PC or NC layer and it would create a composition gradient that can change the electronic functions at the interfaces. Moreover, the substantial absence of Cu and S concentration differences between the contact layers PC, NC and the photovoltaic layer PV may allow the use of relatively high temperatures during manufacturing since the absence of a concentration gradient for Cu and/or S between the layers reduces the driving force for diffusion (Cu has a high diffusion coefficient, and thus is most prone to diffuse). At the same time a high temperature process may improve the crystallinity of the layers as they form.

The solar cell 1 comprising the sequence of layers PC, PV, and NC, as described above, comprises actually a single quaternary chalcogenide compound Cu₂A_{X(d)}B_{Y(d)}S₄ in which the concentrations X(d) and Y(d) of elements A and B, respectively, vary with the depth, d, in the chalcogenide layer, such as to realize a transition from p-type to n-type conductivity in the layer without changing the lattice structure and with minimum change of lattice constant. In this way a homojunction solar cell is obtained, with such physical and electronic properties that it can substitute a Copper Indium Sulphide based thin-film solar cell.

A thin-film based solar cell comprising a thin-film photovoltaic layer PV of a quaternary chalcogenide compound Cu₂A_{X}B_{Y}S₄, a p-type contact layer PC of a quaternary compound p-Cu₂A_{Xp}B_{Yp}S₄, and a n-type contact layer NC of a quaternary compound n-Cu₂A_{Xn}B_{Yn}S₄ as described above can be manufactured by a thin-film deposition process.

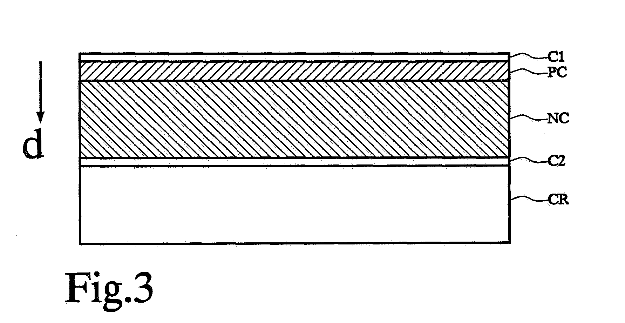

In the chalcogenide solar cell 1, the p-type contact layer PC has preferably a thickness of less than about one tenth of micron, in order to allow most incident light to be passed to photovoltaic layer PV. The photovoltaic layer PV has preferably a thickness of at least half a micron to provide good light absorption. The thickness of the n-type contact layer NC is preferably limited to provide a short pathway for charges and to avoid needless use of material. For example the thickness of the total chalcogenide (PC-PV-NC) layer may be up to two micron. A thicker p-type layer PC may also be used. In this case most photo conversion will occur in p-type layer PC, hence the photovoltaic layer PV may be omitted (see Figure 3 of second embodiment: p-n configuration). In this case, preferably the p-type layer PC has a thickness of at least half a micron, and the total (PC-NC) chalcogenide layer may be up to two micron.

Although examples have been shown with homogeneous layers, i.e. layers where Xp Yp are constant and/or X, Y are constant and/or Xn, Yn are constant, it should be understood that Xp Yp and/or X, Y and/or Xn, Yn, may also vary within the layers, within limits that retain the required conductivity type and lattice parameters. Thus, the junctions between the layers may be part of a gradual variation of X(d) and Y(d) as a function of depth in the layer.

Although an embodiment has been shown wherein the n-type contact layer lies between the substrate and the p-type contact layer, alternatively the order of the contact layers may be reversed, the p-type contact layer lying between the substrate and the p-type contact layer.

As used herein, any layer in the device wherein the majority of the photo conversion occurs, be it the intrinsic layer PV, or a p-type layer, or an n-type layer, will be called "photoactive" layer. As will be understood, "photoactive" in this sense means that the photoactive layer is sufficiently thick to absorb a substantial amount of light, say at least half a micron, and that the photoactive layer is located to receive a substantial amount of light from the outside, because there are no thick absorbing layers between it and the outside of the device.

Any method of deposition may be used to form the layers, but it is preferred to use deposition methods that minimize diffusion. To reduce costs it is preferred to use a single type of thin-film deposition process to form each of the layers NC, PV, PC of the solar cell 1. On a substrate SB, an n-type contact layer NC is formed. Next, the photovoltaic layer PV is formed. Finally, the p-type contact layer PC is formed. Optionally, a transparent capping layer (not shown) is formed that covers the top layer of the solar cell.

Lithographic processes may be used to provide a pattern in the semiconductor layers and the first and second electrical conductors C1, C2, which connect to the p-type contact layer PC and the n-type contact layer NC, respectively. However, formation of the conductors may be integrated with the growth/formation process of the homojunction stack PC, PV, NC. In case the substrate SB is transparent, the stacking order of the layers PC, PV, NC may be reversed.

In the embodiment in which the n-type contact layer NC consists of n-Cu₂A_{Xn}B_{Yn}S₄ and the p-type contact layer PC of p-Cu₂A_{Xp}B_{Yp}S₄, the same deposition process for the contact layers PC, NC can be used as for the photovoltaic layer PV but with different deposition parameters, realized for example by varying the concentration of precursors during a continuing deposition process. This allows an efficient manufacturing process in which the solar cell can be formed in a single deposition tool.

For example, such a single deposition tool may be a roll-to-roll spraying process.

For deposition of the n-Cu₂A_{Xn}B_{Yn}S₄ layer deposition the precursor concentration Xn for element A and precursor concentration Yn for element B are adapted relative to the growth rates of the other elements and the ratio of the relative amounts Xn, Yn of element A and element B is selected in such a way that the compound n-Cu₂A_{Xn}B_{Yn}S₄ with electronic characteristics of a n-type semiconductor is deposited, while the crystalline structure of the compound n-Cu₂A_{Xn}B_{Yn}S₄ is substantially identical to the crystalline structure of the compound Cu₂A_{X}B_{Y}S₄ of the photovoltaic layer PV. After the growth/formation of the NC layer comprising n-Cu₂A_{Xn}B_{Yn}S₄ is completed, the ratio of precursors of the elements Cu, A, B, and S and the deposition parameters are adapted in such a way that the PV layer comprising the compound Cu₂A_{X}B_{Y}S₄ is formed. Then, the ratio of the precursors of the elements Cu, A, B and S and the deposition parameters are adapted such that a p-type contact layer PC consisting of the p-Cu₂A_{Xp}B_{Yp}S₄ compound is formed. The changes of the deposition parameters need not be abrupt. Preferably, a gradually varying change is used.

For example, the NC, PV, and PC layers of a solar cell 1 comprising, respectively, Cu₂Zn_{0.95}Sn_{1.05}S₄, Cu₂ZnSnS₄, and Cu₂Zn_{1.05}Sn_{0.95}S₄, chalcogenides, can be deposited by a spray process in which precursor solutions containing compounds of Cu, Zn, Sn, and S are sprayed onto the growing deposition surface of the solar cell. An apparatus with vessels for respective precursor solutions may used, coupled to a nozzle. In operation solutions may be fed to the nozzle successively from different vessels, to form droplets of the solutions. Preferably the substrate SB and/or the atmosphere near the substrate is heated sufficiently to cause the droplets to evaporate adjacent the deposition surface. The compounds from the vaporized solution then react at the deposition surface to form the layer.

In one example precursor solutions the composition of the precursor solutions containing compounds of Cu, Zn, Sn, and S can be as follows: initially, a solution containing a ratio of Cu:Zn:Sn:S=2.2:0.95:1.05:7 is used to deposit the NC layer of Cu₂Zn_{0.95}Sn_{1.05}S₄, then the concentration is changed to Cu:Zn:Sn:S=2.2:1:1:7 for the deposition of the PV layer of Cu₂ZnSnS₄, and then the ratio is changed to Cu:Zn:Sn:S=2.2:1:05:0:95:7 to deposit the PC layer of Cu₂Zn_{1.05}Sn_{0.95}S₄. The deposition parameters such as temperature, pressure, and spraying time are adjusted so to obtain the desirable layer thickness. Suitable ratio's in the solutions and deposition parameters may be selected experimentally, by observing the resulting Cu:Zn:Sn:S ratio's in the deposited layer.

Valves may be used between the vessels and the nozzle, the valves being opened successively. Alternatively, different nozzles may be used for the solutions different vessels. As another alternative the solution may be formed by mixing compounds from different vessels, using for example regulated pressures or adjustable valves to control the ratio of the compounds.

It is conceivable that the NC layer is manufactured in such a way that the NC layer exhibits a composition gradient. At the side of the interface with the substrate SB the composition of the NC layer may be n-Cu₂A_{Xn}B_{Yn}S₄ with n-type conductivity and it changes over the thickness dn of the NC layer towards a composition Cu₂A_{X}B_{Y}S₄ similar to the composition of the PV layer.

It is conceivable that the PC layer is manufactured in such a way that the PC layer exhibits a composition gradient. At the side of the PV layer with the thickness dv the composition of the PC layer may be Cu₂A_{X}B_{Y}S₄ and gradually changes over the thickness dp of the PC layer towards a composition p-Cu₂A_{Xp}B_{Yp}S₄ with p-type conductivity.

In this manner a homojunction solar cell with a p-i-n configuration is formed. As it will be appreciated by the skilled person, the above sequence of deposition processes to form the solar cell has an advantage in that a single deposition tool can produce all three layers PC, PV, NC without any interruptions for relocation of the substrate SB to another tool. Also, it will be appreciated that at least the deposition rates of the elements A and B (or their ratio) must be adaptable in order to allow the formation/growth of the p-type (p-Cu₂A_{Xp}B_{Yp}S₄), intrinsic type (Cu₂A_{X}B_{Y}S₄) and/or n-type (n-Cu₂A_{Xn}B_{Yn}S₄) chalcogenide materials.

Clearly, a further advantage is that the layers sequence of the p-type contact layer PC, the photovoltaic layer PV, and the n-type contact layer NC of the homojunction solar cell may consist of a single type of crystal structure, which reduces any deterioration of the electronic properties due to the absence of interfaces between the respective layers.

In the above example of manufacturing the solar cell, the formation of the layers PC, PV, NC on the substrate SB was illustrated by means of a spraying process in which at least the elements A and B can be sprayed at individually controllable rates. It is noted that other deposition processes in which the deposition rate of each individual element Cu, A, B and S can be controlled separately from the other elements can be used to manufacture the layers PC, PV, NC on the substrate SB.

For example, deposition processes such as spray deposition technology, sputtering, atomic layer growth, molecular beam epitaxy, and other physical or chemical vapour deposition techniques can be used. For low cost of manufacturing the thin-film deposition process can be one among spray deposition, atmospheric plasma deposition, electrochemical bath deposition, screen printing, casting or any other thin-film deposition process, with the requirement that for the vacuum techniques low temperature (much lower than for techniques using atmospheric pressure) is required. The use of deposition techniques at atmospheric pressure allows the use of higher temperatures without much increased risk of diffusion.

In Figure 3 a second embodiment of the solar cell is shown. The solar cell comprises a substrate SB on which a multilayer thin-film has been deposited. An n-type layer NC is deposited on a surface of the substrate SB. Over the n-type layer NC a p-type layer PC is deposited. The n-type layer NC has a thickness dn2. The p-type layer PC has a thickness dp2.

Optionally, a buffer layer (not shown) may be located between the n-type layer NC and the p-type layer PC. Contacts C1, C2 to the p-type layer PC and the n-type layer NC, respectively are schematically indicated.

The p-type layer PC consists of p-type quaternary chalcogenide material (p-Cu₂A_{Xp}B_{Yp}S₄) and the n-type layer PC consists of n-type quaternary chalcogenide material (n-Cu₂A_{Xn}B_{Yn}S₄), in which the concentrations Xp and Xn, and Yp and Yn of elements A and B, respectively, are within the limits described in reference with the first embodiment.

Due to the fact that Cu₂A_{Xp}B_{Yp}S₄ chalcogenide material is a direct semiconductor with high photonic absorption it is feasible to have a solar cell comprising only a p-n junction (i.e., the p-type layer in direct contact the n-type layer) without intrinsic material (i.e., Cu₂A_{X}B_{Y}S₄) in between. In this case it is preferable that the thickness of the p-type layer is at least half a micron, and this layer is placed over the n-type layer, so that sufficient photon absorption takes place.

Similarly, due to the fact that Cu₂A_{Xn}B_{Yn}S₄ chalcogenide material is a direct semiconductor with high photonic absorption it is feasible to have a solar cell comprising only a p-n junction (i.e., the p-type layer in direct contact the n-type layer) without intrinsic material (i.e., Cu₂A_{X}B_{Y}S₄) in between. In this case it is preferable that the thickness of the n-type layer is at least half a micron, and this layer is placed over the p-type layer, so that sufficient photon absorption takes place.

Similarly as described above with reference to the first embodiment, the p-type layer and the n-type layer have the same crystal structure and a homojunction between the two layers (PC, NC) is formed.

The manufacturing of the solar cell according to the second embodiment is similar to that described for the solar cell of the first embodiment, except that no intrinsic layer (photovoltaic layer) PV is formed in between the p-type and n-type layers.

Note moreover that also quaternary Selenide compounds Cu₂A_{X}B_{Y}Se₄ are conceivable as photovoltaic layer PV instead of quaternary Sulphide compounds Cu₂A_{X}B_{Y}S₄. Also, quaternary Selenide compounds Cu₂A_{Xn}B_{Yn}Se₄ and Cu₂A_{Xp}B_{Yp}Se₄ are conceivable as n-type contact layer NC and p-type contact layer PC, respectively, instead of quaternary Sulphide compounds Cu₂A_{Xn}B_{Yn}S₄ and Cu₂A_{Xp}B_{Yp}S₄.

As will be appreciated the resulting thin-film solar cell does not require Indium. Nevertheless, due to the similarity of the structure of the photovoltaic layer Cu₂A_{X}B_{Y}S₄ with the structure of CuInS₂, the solar cell may have photovoltaic properties similar to those of Copper Indium Sulphide based solar cells.

The solar cell accordingly has an improved efficiency in comparison to heterojunction chalcogenide-based solar cells. This is due to the high theoretical value of the open voltage achievable in this solar cell configuration (i.e., the open voltage can be as high as the value of the bandgap), and due to low charge recombination at interfaces as less interfaces are present.

Moreover, by using n-type and p-type contact layers with a similar structure as the photovoltaic layer, the coherency between each contact layer and the photovoltaic layer is improved, and no additional deposition steps are needed to create a buffer layer between the n-type contact layer and the photovoltaic layer or between the photovoltaic layer and the p-type contact layer. It will be appreciated by the person skilled in the art that other alternative and equivalent embodiments of the invention can be conceived and reduced to practice without departing form the true spirit of the invention, the scope of the invention being limited only by the appended claims.

## Claims

1. A thin-film solar cell (1) comprising first and second electrical contacts and a chalcogenide layer of Cu₂A_{X(d)}B_{Y(d)}Z₄ quaternary chalcogenide compounds between the first and second electrical contacts, wherein A is one of the group of Mg, Ca, Sr, Ba, Sc, Y, La, Eu, Gd, Er, Yb, Mn, Fe, Ag, Au, Zn, A1, Ga, Ge, Sn and Sb and B one from the group of Sc, Y, La, Ce, Gd, Er, Yb, Fe, Al, Ga, Si, Ge , Sn, P, Sb, Ti, Zr, Hf, V, Nb, Ta, Mo, W and Re, with element B being different from element A, and element Z is one from a group of elements S and Se, wherein the relative amounts X(d), Y(d) of A and B vary as a function of depth, d, within the layer, having values that result in p-type conductivity at a depth adjacent the first electrical contact and values that result in n-type conductivity at a depth adjacent the second electrical contact, the relative amounts X(d), Y(d) having values that correspond to Cu₂A_{X(d)}B_{Y(d)}Z₄ compounds with substantially coherent crystal lattices throughout the layer as a function of the depth.

2. A thin-film solar cell (1) according to claim 1, wherein the relative amounts X(d), Y(d) vary as function of depth so that a photoactive sub-layer of intrinsic conductivity type is present in the layer in a range of depth between depths where the layer has p-type conductivity and depths where the layer has n-type conductivity.

3. Thin-film solar cell according to claim 2, wherein the relative amounts X(d), Y(d) in the photoactive sub-layer have values at which the material of the photoactive sub-layer sub-layer has a bandgap energy between about 1.2 and about 1.8 eV.

4. A thin-film solar cell (1) according to claim 2, wherein the photoactive sub-layer PV has a depth of at least half a micron.

5. A thin-film solar cell (1) according to claim 1, wherein the relative amounts X(d), Y(d) vary as function of depth so that p-n homojunction is present in the layer.

6. A thin-film solar cell (1) according to claim 5, comprising a photoactive sub-layer of p-type conductivity or n-type conductivity and a thickness of at least half a micron, and wherein the relative amounts X(d), Y(d) in the photoactive sub-layer have values at which the material of the photoactive sub-layer has a bandgap energy between about 1.2 and about 1.8 eV.

7. Thin-film solar cell according to any one of the preceding claims, comprising a substrate (SB) and a buffer layer between the sub-layers with different type of conductivity in the chalcogenide layer.

8. Thin-film solar cell according to any one of the preceding claims, comprising a capping layer on the chalcogenide layer.

9. Method of manufacturing the thin-film solar cell (1) on a substrate, the method comprising:
- forming an chalcogenide layer by depositing Cu₂A_{X(d)}B_{Y(d)}Z₄ compounds wherein A is one of the group of Mg, Ca, Sr, Ba, Sc, Y, La, Eu, Gd, Er, Yb, Mn, Fe, Ag, Au, Zn, Al, Ga, Ge, Sn and Sb and B one from the group of Sc, Y, La, Ce, Gd, Er, Yb, Fe, Al, Ga, Si, Ge , Sn, P, Sb, Ti, Zr, Hf, V, Nb, Ta, Mo, W and Re, with element B being different from element A, and element Z is one from a group of elements S and Se,
- varying deposition parameters during formation of the chalcogenide layer, to vary the relative amounts X(d), Y(d) of A and B, respectively, as a function of depth, d, in the chalcogenide layer, under a restriction that combinations of values of the varying relative amounts X(d), Y(d) are those of Cu₂Ax_{(d)}B_{Y(d)}Z₄ compounds with substantially coherent respective crystal lattices, the combinations of values of the relative amounts X(d), Y(d) varying between a first combination of values that results in p-type conductivity and a second combination of values that results in n-type conductivity.

10. Method of manufacturing a thin-film solar cell (1) according to claim 9, the method further comprising:
- providing relative amounts X(d), Y(d) in a part of the chalcogenide layer with a combination of values of the relative amounts X(d), Y(d) that results in intrinsic conductivity, between the deposition with the first and second combination of values at least during deposition of half a micron of the depth of the chalcogenide layer.

11. Method of manufacturing a thin-film solar cell (1) according to claims 9 or 10 wherein the combination of values of the relative amounts X(d), Y(d) that results in the conductivity type of a photoactive sub-layer is maintained at least during deposition of half a micron of the depth of the chalcogenide layer.

12. Method of manufacturing a thin-film solar cell (1) according to claim 9 - 11 wherein the deposition of the chalcogenide layer is performed under non-vacuum conditions.

13. Method of manufacturing a thin-film solar cell (1) according to claim 12, wherein the deposition is performed by spraying at atmospheric pressure.
